# EUROPEAN PATENT APPLICATION

(11) **EP 3 240 192 A1**
(43) Date of publication of application: **01.11.2017**
(21) Application number: 16166815.7
(22) Date of filing: 25.04.2016
(51) Int. Cl.: H03F 3/45

(54) **INSTRUMENTATION AMPLIFIER CIRCUIT**

(71) Applicant: Nokia Technologies Oy, 02610 Espoo (FI)
(72) Inventor: BLOMQVIST, Kim, 02650 Espoo (FI); TEIKARI, Ilari, 00400 Helsinki (FI)
(74) Representative: Espatent Oy

(57) **Abstract**

An electronic circuit comprising: an instrumentation amplifier circuit comprising a pair of instrumentation amplifiers arranged to provide differential output, and a common-mode feedback circuit arranged to couple common-mode output of the pair of instrumentation amplifiers to input of the pair of instrumentation amplifiers. Disclosed is also an electronic circuit comprising an instrumentation amplifier circuit comprising a pair of instrumentation amplifiers, wherein the pair of instrumentation amplifiers is configured to operate as a constant current source circuit configured to feed current to biomedical substance.

## Description

### TECHNICAL FIELD

The present application generally relates to instrumentation amplifier circuits. The disclosed electronic circuit arrangements may be used for example in electrocardiogram (ECG) measurements and/or in other biomedical instrumentation solutions but the application is not exclusively related to these application environments and the disclosed arrangements can be used elsewhere.

### BACKGROUND

This section illustrates useful background information without admission of any technique described herein representative of the state of the art.

Biomedical measurements set certain requirements to measurement equipment (to characteristics of the measurement circuit).

For example, electrocardiography (ECG) measurement requires rejection of common-mode voltage. The source of common-mode voltage is typically the AC (alternating current) mains frequency of 50 Hz or 60 Hz of the electric power supply, or overpotentials caused by the half-cell potential of the electrodes that are being used. One may define overpotential as the difference between the half-cell potential and the zero potential. It appears as a dc offset to the measurement instrument. In the case of an ECG, the differential voltage across a person's chest (the cardiac signal) is typically 1.8 mV in amplitude riding on a dc offset of up to 300 mV.

Some biomedical measurements, such as electrodermal activity (EDA, aka GSR galvanic skin response) measurements, body or tissue conductivity (aka bioimpedance) measurements or impedance plethysmography (IPG) measurements, e.g. impedance cardiography (ICG), require injecting a constant direct or alternating current (aka DC or AC) into the biomedical substance that is measured.

### SUMMARY

Various aspects of examples of the invention are set out in the claims.

According to a first example aspect of the present invention, there is provided an electronic circuit comprising
an instrumentation amplifier circuit comprising a pair of instrumentation amplifiers arranged to provide differential output, and
a common-mode feedback circuit arranged to couple common-mode output of the pair of instrumentation amplifiers to input of the pair of instrumentation amplifiers.

In an embodiment, the electronic circuit further comprises a first impedance network and a second impedance network, wherein
the first impedance network is coupled to input of the pair of instrumentation amplifiers,
the second impedance network is coupled to output of the pair of instrumentation amplifiers, and
the common-mode feedback circuit is arranged to couple a common-mode output of the second impedance network to a common-mode input of the first impedance network.

In an embodiment, the electronic circuit further comprises a first low pass filter coupled to the input of the pair of instrumentation amplifiers. The first low pass filter may be a differential low pass filter.

In an embodiment, the electronic circuit further comprises an output direct current block coupled to the output of the pair of instrumentation amplifiers.

In an embodiment, the electronic circuit further comprises a second low pass filter coupled to the output of the pair of instrumentation amplifiers. The second low pass filter may be a differential low pass filter.

In an embodiment, the electronic circuit further comprises a switch in the common-mode feedback circuit.

In an embodiment, in a first setting, the switch is configured to couple the common-mode feedback circuit to input of the pair of instrumentation amplifiers, and in a second setting, the switch is configured to couple the common-mode feedback circuit to a substance that is being measured. In an embodiment, in a first setting, the switch is configured to couple the common-mode feedback circuit to input of the pair of instrumentation amplifiers, and in a second setting, the switch is configured to couple reference voltage to input of the instrumentation amplifiers.

In an embodiment, the electronic circuit is configured to measure certain biomedical substance.

In an embodiment, the electronic circuit further comprises input electrodes configured to provide contact between the biomedical substance and the electronic circuit and feedback electrodes configured to couple the common-mode feedback circuit to the biomedical substance. This embodiment may be implemented for example in a patch like device directly attached to the biomedical substance.

In an embodiment, the electronic circuit further comprises shielded cables configured to couple the input electrodes to components of the electronic circuit, wherein the shields of the cables are configured to couple the common-mode feedback circuit to the biomedical substance. This embodiment may be implemented for example in an arrangement where the components of the electronic circuit (the actual measurement device) may be further away from the biomedical substance.

In an embodiment, the electronic circuit further comprises buffer amplifiers coupled to the input of the pair of instrumentation amplifiers.

In an embodiment, the electronic circuit further comprises a current source circuit comprising an instrumentation amplifier circuit, wherein the current source circuit is configured to feed current into the biomedical substance.

In an embodiment, the current source circuit comprises a pair of instrumentation amplifiers, two operational amplifiers connected as voltage followers and two resistors.

In an embodiment a biomedical instrumentation arrangement comprises any preceding electronic circuit.

In an embodiment, an electrocardiography measurement arrangement comprises any preceding electronic circuit.

According to a second example aspect of the present invention, there is provided an electronic circuit comprising:
an instrumentation amplifier circuit comprising a pair of instrumentation amplifiers, wherein the pair of instrumentation amplifiers is configured to operate as a constant current source circuit configured to feed current to biomedical substance.

In an embodiment, the constant current source circuit of the second example aspect further comprises two operational amplifiers connected as voltage followers and two resistors.

In an embodiment the electronic circuit of the second example aspect, further comprises a measurement circuit configured to measure said biomedical substance, wherein the measurement circuit comprises
an instrumentation amplifier circuit comprising a pair of instrumentation amplifiers arranged to provide differential output, and
a common-mode feedback circuit arranged to couple common-mode output of the pair of instrumentation amplifiers to input of the pair of instrumentation amplifiers.

In an embodiment the electronic circuit of the second example aspect, further comprises any feature disclosed above in connection with the first example aspect or any combination thereof.

According to a third example aspect of the present invention, there is provided a method comprising
arranging a biomedical instrumentation measurement using an instrumentation amplifier circuit comprising a pair of instrumentation amplifiers arranged to provide differential output, and a common-mode feedback circuit arranged to couple common-mode output of the pair of instrumentation amplifiers to input of the pair of instrumentation amplifiers.

According to a fourth example aspect of the present invention, there is provided a method comprising arranging an instrumentation amplifier circuit comprising a pair of instrumentation amplifiers to operate as a constant current source circuit configured to feed current to biomedical substance.

Different non-binding example aspects and embodiments of the present invention have been illustrated in the foregoing. The embodiments in the foregoing are used merely to explain selected aspects or steps that may be utilized in implementations of the present invention. Some embodiments may be presented only with reference to certain example aspects of the invention. It should be appreciated that corresponding embodiments may apply to other example aspects as well.

### BRIEF DESCRIPTION OF THE DRAWINGS

For a more complete understanding of example embodiments of the present invention, reference is now made to the following descriptions taken in connection with the accompanying drawings in which:
Figs. 1a-1c show ECG measurement arrangements according to some embodiments of the invention;
Figs. 2a-2f are circuit diagrams of example embodiments;
Fig. 3a shows a bioinstrumentation arrangement according to an embodiment of the invention; and
Fig. 3b is a circuit diagram of an example embodiment.

### DETAILED DESCRIPTON OF THE DRAWINGS

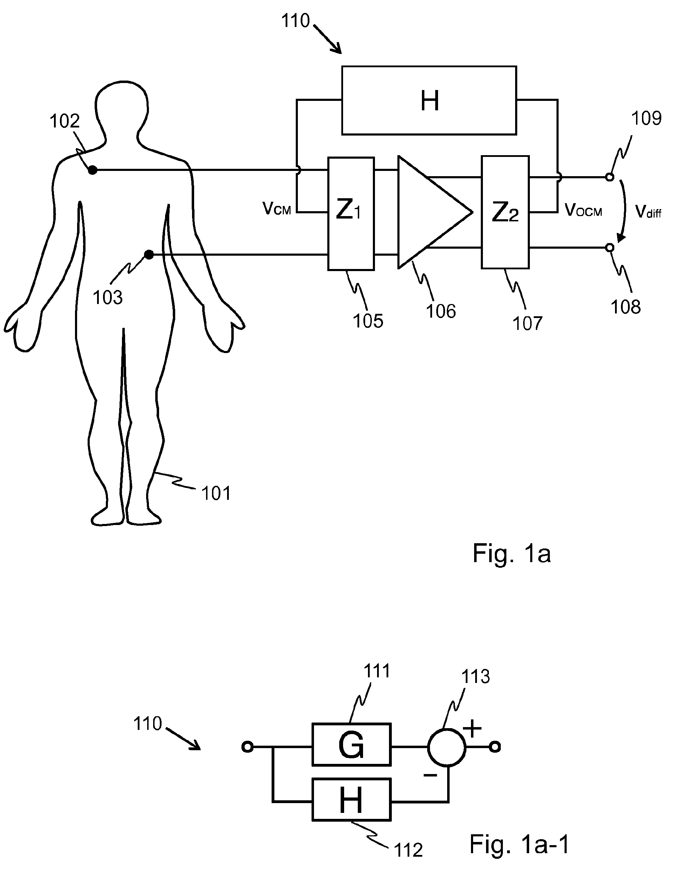

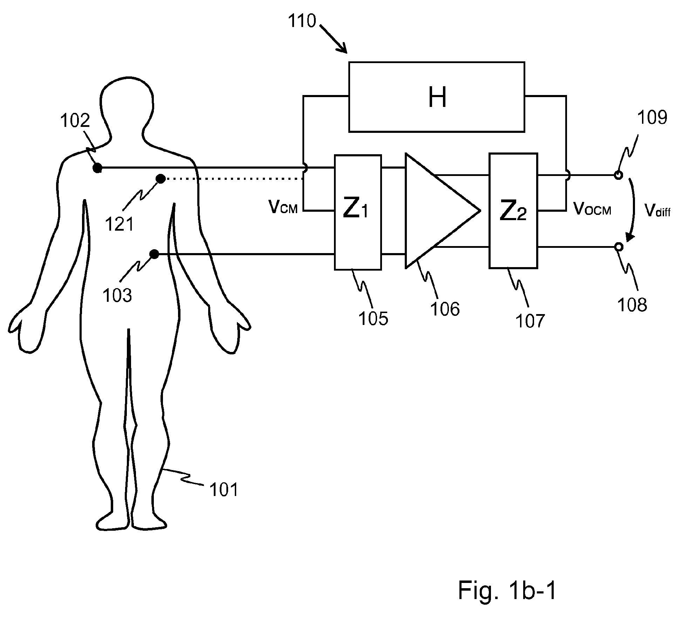

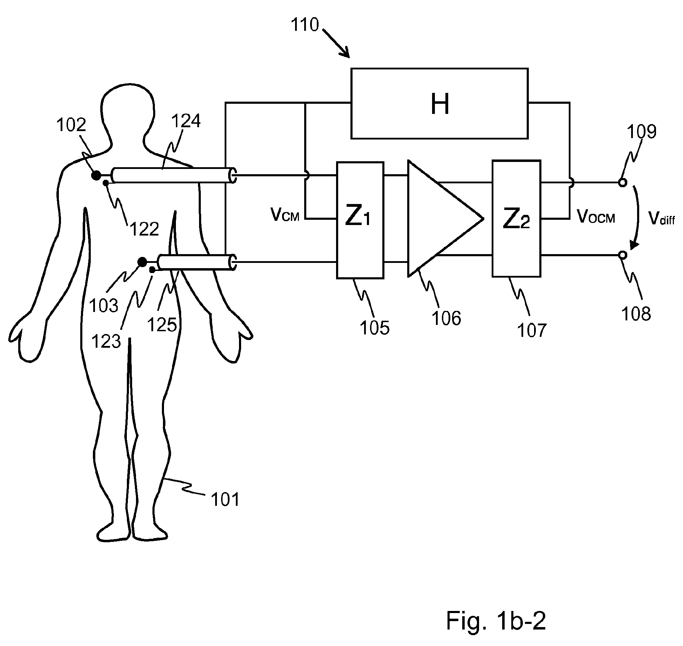

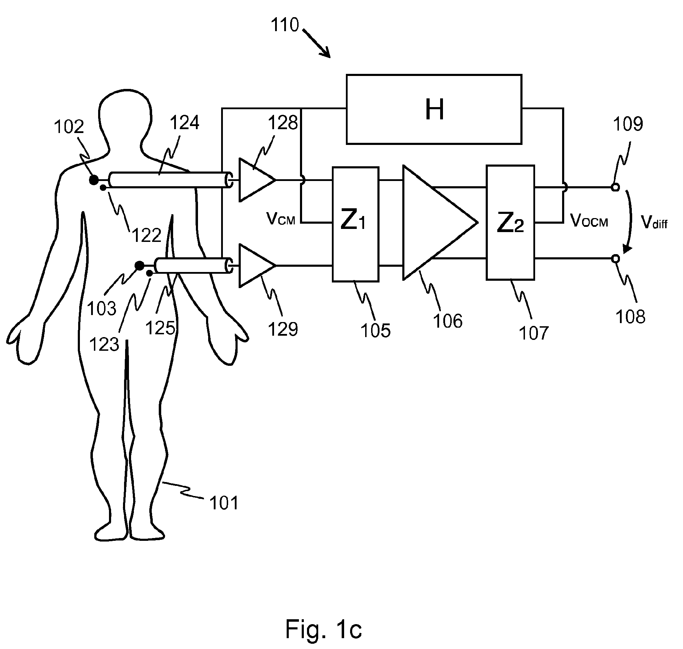

Example embodiments of the present invention and its potential advantages are understood by referring to Figs. 1 a through 3b of the drawings. In this document, like reference signs denote like parts or steps.

In this document, the terms couple and connect may refer to direct contact between components or to coupling through some intervening component(s).

Various embodiment of the invention disclosed in the following relate to electronic circuits used in biomedical measurements. Herein, the term biomedical measurements is generally used to refer to electronic measurements of biomedical substance or organic material. The biomedical substance may be for example body or tissue of a living organism (e.g. human being) or a cell sample. Examples of biomedical measurements comprise for example electrocardiography (ECG) measurements, electrodermal activity (EDA, aka GSR galvanic skin response) measurements, body conductivity (aka bioimpedance) measurements, and impedance plethysmography (IPG) measurements, e.g. impedance cardiography (ICG).

In various example embodiments of the invention there is provided an electronic circuit comprising an instrumentation amplifier circuit equipped with a common-mode feedback circuit. The common-mode feedback circuit is configured to couple an output common mode signal of the instrumentation amplifier circuit to input of the instrumentation amplifier circuit. The instrumentation amplifier circuit may be a composite instrumentation amplifier circuit comprising a pair of instrumentation amplifiers arranged to provide differential output. The pair of instrumentation amplifiers may form a composite instrumentation amplifier with a third instrumentation amplifier. Such electronic circuit is well suited for biomedical measurements, e.g. for ECG measurements.

In various example embodiments of the invention there is provided an electronic circuit alternatively or additionally comprising an instrumentation amplifier circuit with a pair of instrumentation amplifiers configured to operate as a constant current source. Such electronic circuit is well suited for biomedical measurements that require injecting a constant alternating current into the biomedical substance that is measured, e.g. for electrodermal activity (EDA, aka GSR galvanic skin response) measurements, body conductivity (aka bioimpedance) measurements, and impedance cardiography (ICG) measurements. The measurement of the biomedical substance is then performed with suitable measurement circuit. In an embodiment the measurement circuit comprises the instrumentation amplifier circuit equipped with the common-mode feedback circuit. That is, the embodiment relating to a constant current source comprising a pair of instrumentation amplifiers may be used together with embodiment relating to an instrumentation amplifier circuit equipped with a common-mode feedback circuit. The use of both of these embodiments concurrently is not mandatory, though.

In the following, various example embodiments are discussed in connection with ECG measurement topologies. Various embodiments are however not necessarily limited to ECG measurements only. Instead the example embodiments can be used other biomedical measurements, too.

Figs. 1a-1c show ECG measurement arrangements according to some embodiments of the invention.

Fig. 1a shows an ECG measurement arrangement with a human body 101 that is being measured. The measurement arrangement comprises input electrodes 102 and 103 to provide contact to the body 101. The input electrodes 102 and 103 convert ECG signals into electrical voltage. The measurement circuitry shown in Fig. 1 a comprises a first impedance network Z1 105, an instrumentation amplifier circuit 106, a second impedance network Z2 107 and a common-mode feedback circuit H 110. The input electrodes 102 and 103 are coupled to input of the first impedance network Z1, output of the first impedance network Z1 is coupled to input of the instrumentation amplifier circuit 106, and output of the instrumentation amplifier circuit 106 is coupled to a second impedance network Z2. Differential voltage V_{diff} over output pins 108 and 109 of the second impedance network Z2 represents the measured ECG signals. The differential voltage V_{diff} may be input to a further instrumentation amplifier to provide single ended output.

The common-mode feedback circuit 110 couples an output common-mode voltage V_{OCM} - of the second impedance network Z2 to a common-mode input V_{CM} of the first impedance network Z1. The output common-mode voltage V_{OCM} may be defined as a voltage that is left from the common-mode voltage present at the input side of the amplifier after it has propagated through the amplifier 106.

Fig. 1a-1 shows an example implementation of the common mode feedback circuit H 110. The common-mode feedback circuit H 110 comprises a further negative feedback circuit that comprises a forward gain element G 111 (this being forward gain of the common mode feedback circuit), and a feedback path element H 112, and a summing element 113 arranged to negatively sum the feedback path H 112 to the input of the forward gain element G 111.

Figs. 1b-1 and 1b-2 show an ECG measurement arrangement according to another embodiment of the invention. In this example embodiment the common-mode feedback is coupled (directly or indirectly e.g. through some protective component(s)) to the measured subject.

Similarly to Fig. 1a also Figs. 1b-1 and 1b-2 show a human body 101 that is being measured. Likewise the measurement arrangement of Figs. 1b-1 and 1b-2 comprises input electrodes 102 and 103 to provide contact to the body 101 and the measurement circuitry of Figs. 1b-1 and 1b-2 comprises a first impedance network Z1 105, an instrumentation amplifier circuit 106, a second impedance network Z2 107 and a common-mode feedback circuit H 110.

In Fig. 1b-1 the common-mode feedback from the common-mode feedback circuit H 110 is coupled to the body 101 through contact 121 (in addition to being coupled to the first impedance network Z1 105. As an example, this embodiment may be implemented in a patch like device directly attached to the biomedical substance. In Fig. 1b-2 the input electrodes 102 and 103 are coupled to the measurement circuit using shielded cables (Fig. 1b-2 shows cable shields 124 and 125). That is, in this embodiment there may be certain distance between the body 101 and the measurement circuit. The common-mode feedback from the common-mode feedback circuit H 110 is coupled to cable shields 124 and 125 and through the cable shields to contacts 122 and 123 that provide contact to the body 101. Thereby the common-mode feedback is coupled to the body 101.

Fig. 1c shows a further variation of the measurement arrangement of Fig. 1b-2. Similarly to Figs. 1a, 1b-1 and 1b-2 also Fig. 1c shows a human body 101 that is being measured. Likewise the measurement arrangement of Fig. 1c comprises input electrodes 102 and 103 to provide contact to the body 101 and the measurement circuitry of Fig. 1c comprises a first impedance network Z1 105, an instrumentation amplifier circuit 106, a second impedance network Z2 107 and a common-mode feedback circuit H 110. Similarly to Fig. 1b-2 also Fig. 1c comprises coupling of the common-mode feedback to the body 101 through the cable shields 124 and 125.

The measurement circuitry of Fig. 1c further comprises buffers 128 and 129 between input electrodes 102, 103 and the first impedance network Z1. The coupling of the common-mode feedback to the body 101 enables the use of buffers 128 and 129.

It is to be noted that using cable shields for conveying the common-mode feedback to the body is only one example implementation. Also some other solution may be used.

The examples of Figs. 1b-1, 1b-2 and 1c, the common-mode feedback circuit may comprise a switch that can be used to connect the common mode feedback to the first impedance network Z1 or to the body 101 or to both of these.

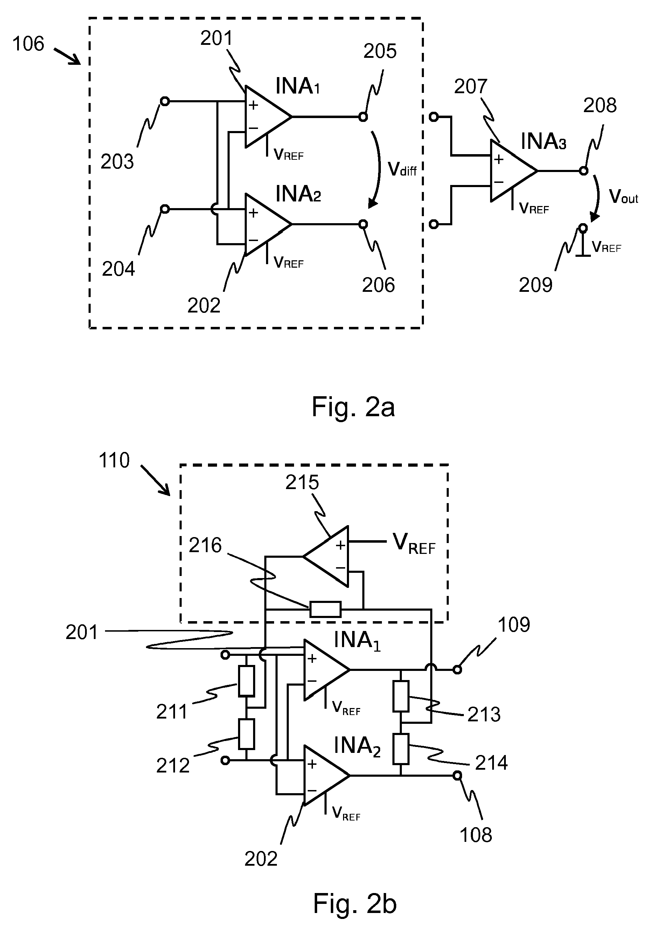

Figs. 2a-2f are circuit diagrams of example embodiments.

Fig. 2a shows an example circuit diagram of an instrumentation amplifier circuit 106 of Figures 1a-1c. The shown instrumentation amplifier circuit comprises two (a pair of) instrumentation amplifiers INA1, 201 and INA2, 202. Input pin 203 is connected to non-inverting input of the INA1 and to inverting input of the INA2 and input pin 204 is connected to inverting input of the INA1 and to non-inverting input of the INA2. The pair of instrumentation amplifiers INA1 and INA2 provides a differential output V_{diff} over pins 205 and 206. Fig. 2a shows also a third instrumentation amplifier INA3 207. The three instrumentation amplifiers INA1, INA2 and INA3 form a composite instrumentation amplifier. The differential voltage V_{diff} is input to the third instrumentation amplifier INA 3 to provide single ended output over pins 208 and 209, pin 209 being a reference voltage.

Fig. 2b shows an example implementation of the common mode feedback circuit 110 of Figures 1a-1c. The common mode feedback circuit 110 comprises an amplifier 215 and a resistor 216 that couples output of the amplifier to inverting input of the amplifier 215. Further Fig. 2b shows a pair of instrumentation amplifiers INA1, 201 and INA2, 202 that form the instrumentation amplifier circuit 106 of Figures 1a-1c as well as input resistors 211 and 212 forming the first impedance network Z1 of Figures 1a-1c and output resistors 213 and 214 forming the second impedance network Z2 of Figures 1a-1c. The common mode feedback circuit 110 (output of the amplifier 215) is coupled to the instrumentation amplifiers 201 and 202 through the input resistors 211 and 212. Input offset currents of INA1 and INA2 are allowed to flow back to input of the amplifier 215. (Differential) output of the measurement circuit is measured over output pins 108 and 109.

The differential output may be input into a further instrumentation amplifier to provide single ended output. This applies to output of the following figures, too.

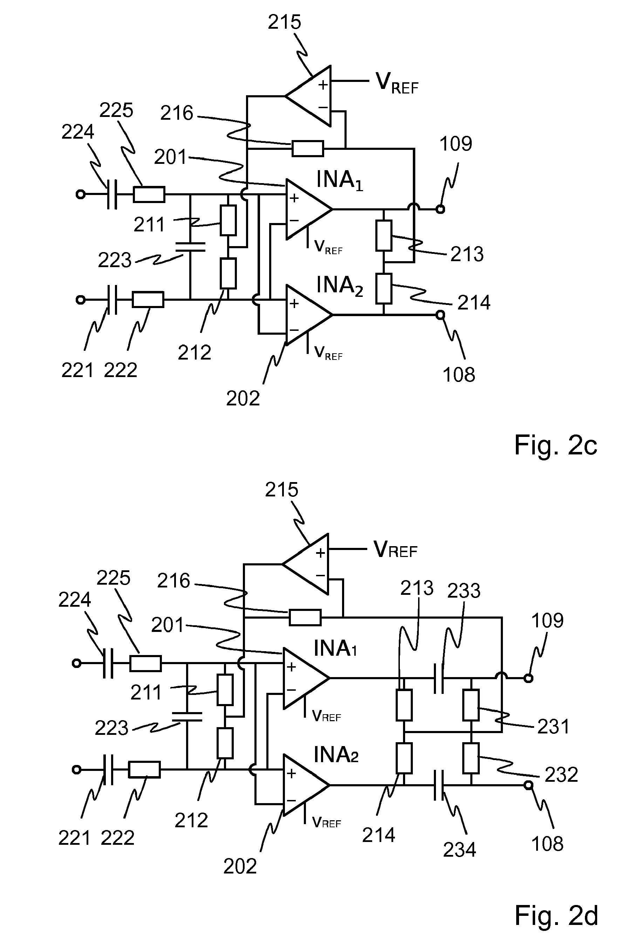

Fig. 2c shows a further variation according to an example embodiment. Similarly to Fig. 2b also Fig. 2c comprises an amplifier 215 and a resistor 216 forming the common-mode feedback circuit 110 of Figures 1a-1c, two instrumentation amplifiers INA1, 201 and INA2, 202 forming the instrumentation amplifier circuit 106 of Figures 1a-1c, and output resistors 213 and 214 forming the second impedance network Z2 of Figures 1a-1c. Output of the measurement circuit is measured over output pins 108 and 109.

In this example the first impedance network Z1 of Figures 1a-1c comprises input resistors 211 and 212 and additionally a differential low pass filter formed of resistors 222 and 225 and capacitor 223. Further the first impedance network Z1 comprises capacitors 221 and 224 placed in series in input paths to provide AC coupling.

Fig. 2d shows an example where an output DC (direct voltage) block has been added to mitigate the DC offset voltages of the instrumentation amplifiers. Similarly to Figs. 2b and 2c also Fig. 2d comprises an amplifier 215 and a resistor 216 forming the common-mode feedback circuit 110 of Figures 1a-1c, and two instrumentation amplifiers INA1, 201 and INA2, 202 forming the instrumentation amplifier circuit 106 of Figures 1a-1c. Output of the measurement circuit is measured over output pins 108 and 109.

In the example shown in Fig. 2d, the first impedance network Z1 of Figures 1a-1c comprises input resistors 211 and 212 and additionally a differential low pass filter formed of resistors 222 and 225 and capacitor 223. Further the first impedance network Z1 comprises capacitors 221 and 224. This is similar to Fig. 2c, but it is to be noted that also other implementations are possible. For example, the first impedance network Z1 could be similar to that shown in Fig. 2b.

In the example shown in Fig. 2d the second impedance network Z2 of Figures 1a-1c comprises output resistors 213 and 214 and additionally capacitors 233 and 234 and resistors 231 and 232. The capacitors 233 and 234 and resistors 231 and 232 are configured to block DC offset of the INAs 201 and 202.

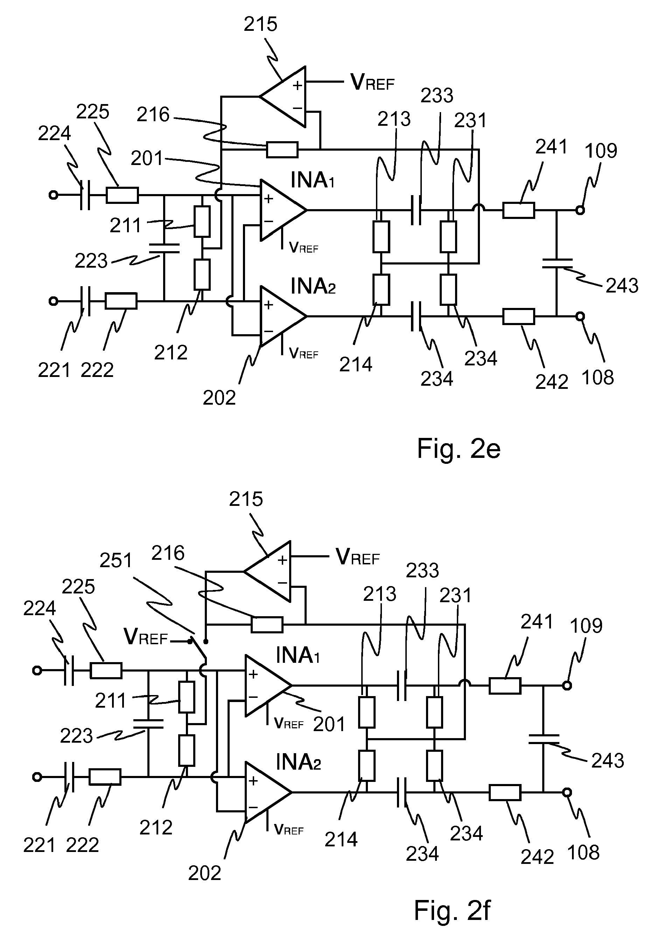

Fig. 2e shows an example where a second differential low pass filter has been added to the output. Similarly to Figs. 2b-2d also Fig. 2e comprises an amplifier 215 and a resistor 216 forming the common-mode feedback circuit 110 of Figures 1a-1c, and two instrumentation amplifiers INA1, 201 and INA2, 202 forming the instrumentation amplifier circuit 106 of Figures 1a-1c. Output of the measurement circuit is measured over output pins 108 and 109.

In the example shown in Fig. 2e, the first impedance network Z1 of Figures 1a-1c comprises input resistors 211 and 212 and additionally a differential low pass filter formed of resistors 222 and 225 and capacitor 223, and capacitors 221 and 224. This is similar to Figs. 2c and 2d, but it is to be noted that also other implementations are possible. For example, the first impedance network Z1 could be similar to that shown in Fig. 2b.

In the example shown in Fig. 2e the second impedance network Z2 of Figures 1a-1c comprises output resistors 213 and 214, capacitors 233 and 234 and resistors 231 and 232 similarly to Fig. 2d. Additionally the second impedance network Z2 comprises a second differential low pass filter formed of resistors 241 and 242 and capacitor 243.

Fig. 2f shows an example with a common mode feedback on/off switch 251. Similarly to Figs. 2b-2e also Fig. 2f comprises an amplifier 215 and a resistor 216 forming the common-mode feedback circuit 110 of Figures 1a-1c, and two instrumentation amplifiers INA1, 201 and INA2, 202 forming the instrumentation amplifier circuit 106 of Figures 1a-1c. Output of the measurement circuit is measured over output pins 108 and 109.

In the example shown in Fig. 2f, the first impedance network Z1 of Figures 1a-1c comprises input resistors 211 and 212 and additionally a differential low pass filter formed of resistors 222 and 225 and capacitor 223, and capacitors 221 and 224. This is similar to Figs. 2c-2e, but it is to be noted that also other implementations are possible. For example, the first impedance network Z1 could be similar to that shown in Fig. 2b.

In the example shown in Fig. 2f, the second impedance network Z2 of Figures 1a-1c comprises output resistors 213 and 214, capacitors 233 and 234, resistors 231, 232, 241 and 242 and capacitor 243 similarly to Fig. 2e. It is to be noted that also other implementations are possible. For example, the second impedance network Z2 could be similar to that shown in one of Figs. 2b-2d.

The switch 251 is configured to connect the common-mode feedback circuit on and off. In the shown example the switch 251 has two positions or settings. In a first position/setting, the switch connects the common-mode feedback circuit to input of the instrumentation amplifiers 201 and 202 through the resistors 211 and 212. In a second position/setting, the switch connects reference voltage V_{REF} to input of the instrumentation amplifiers 201 and 202 through the resistors 211 and 212. In another embodiment, the switch connects, in a first position/setting, the common-mode feedback circuit to input of the instrumentation amplifiers 201 and 202 through the resistors 211 and 212, and in a second position/setting, the switch connects the common-mode feedback circuit to the substance that is being measured (not shown in Fig. 2f). In yet another embodiment there may be a third switch position in which the common-mode feedback circuit is connected both to input of the instrumentation amplifiers 201 and 202 and to the substance that is being measured.

It is to be noted that Fig. 2f shows the switch 251 in one example implementation. It is clear that similar switch can be added also to example implementations of Figs. 2b-2e and other embodiments of the invention.

In an embodiment, some of the resistors shown in examples of Figs. 2b-2f are replaced with switched capacitors. For example one or more of the resistors 211, 212, 222, 225, 241, and 242 may be replaced with switched capacitors.

In an embodiment, V_{REF} voltage in Figs. 2b-2f is connected to VCC/2. This is possible, if single supply is used.

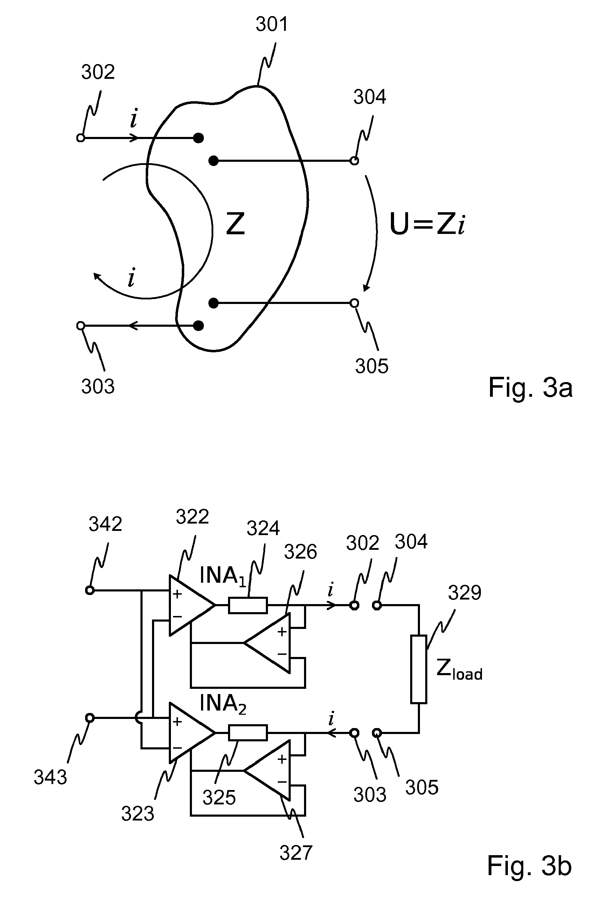

Fig. 3a shows a bioinstrumentation arrangement according to an embodiment of the invention. Fig 3a shows a sample 301 that is being measured. The sample may be some organic or biomedical substance, e.g. a cell sample or tissue. Fig. 3a shows input pins 302 and 303 and voltage pick-up pins 304 and 305. A constant current source circuit is used to inject constant alternating current to input pins 302 and 303 and thereby into the sample 301. Measurement result is obtained by measuring voltage over the voltage pick-up pins 304 and 305. For example one of the circuits shown in Figs. 2b-2f can be included to measure the voltage over the voltage pick-up pins 304 and 305.

In general, for bioinstrumentation purposes it is desirable that a current source has high output impedance to work properly with different sizes of load impedances. Additionally, the instrumentation of the measurement would benefit from having a current source with balanced output (same impedance at both output pins). In previously known circuits the other output pin is ground (low impedance). For example, a Howland circuit and a simple non-inverting operational amplifier circuit do not have balanced current output. Both of these have a ground as other load contact.

Fig. 3b is a circuit diagram of an example embodiment. The shown example circuit provides a constant current source suited for example for bioinstrumentation purposes, e.g. the example shown in Fig. 3a.

Fig. 3b shows an instrumentation amplifier current source that comprises two (a pair of) instrumentation amplifiers 322 and 323, two operational amplifiers 326 and 327 connected as voltage followers and two resistors 324 and 325. Input pins of the circuit of Fig. 3b are connected so that input pin 342 is connected to non-inverting input of the instrumentation amplifier 322 and to inverting input of the instrumentation amplifier 323 and input pin 343 is connected to inverting input of the instrumentation amplifier 322 and to non-inverting input of the instrumentation amplifier 323. The resistors 324 and 325 are placed between outputs of the instrumentation amplifiers 322 and 323 and non-inverting inputs of the operational amplifiers 326 and 327. Outputs of the operational amplifiers 326 and 327 are connected to a reference (REF) pin of the instrumentation amplifiers 322 and 323. The shown instrumentation amplifier circuit may be used to feed constant current to input pins 302 and 303 of the arrangement of Fig. 3a. Measurement over the voltage pick-up pins 304 and 305 may then be performed in any suitable manner using suitable load 329.

Electronic circuits provided in various embodiments may be used for example in respiration, impedance cardiography (ICG), bioelectrical impedance analysis (BIA), electrical impedance tomography (EIT) and electrodermal activity (EDA, aka GSR galvanic skin response) measurements.

Without in any way limiting the scope, interpretation, or application of the claims appearing below, a technical effect of one or more of the example embodiments disclosed herein is that an improved measurement circuit is provided. The measurement circuit with instrumentation amplifier arrangement of various embodiments may be well suited for example for ECG measurements and other biomedical measurements. Another technical effect of one or more of the example embodiments disclosed herein is that measurement in less ideal circumstances are enabled.

Another technical effect of one or more of the example embodiments disclosed herein is that range of tolerated common-mode voltages in instrumentation amplifier circuit is increased. Another technical effect of one or more of the example embodiments disclosed herein is that lower supply voltages may be used in measurement circuit.

Another technical effect of one or more of the example embodiments disclosed herein is that (active) DC suppression is provided in instrumentation amplifier circuit. Another technical effect of one or more of the example embodiments disclosed herein is that increased gain may be provided in instrumentation amplifier circuit. Another technical effect of one or more of the example embodiments disclosed herein is that increased input impedance may be provided as using additional buffer amplifiers is enabled.

Yet another technical effect of one or more of the example embodiments disclosed herein is that less ideal electrodes may be used in biomedical measurements (e.g. ECG measurements). For example, use of different types of electrodes may be enabled and/or use of electrodes with relatively weak contact may be enabled. E.g. electrodes with larger half-cell potential may be used.

Yet another technical effect of one or more of the example embodiments disclosed herein is that they may enable AC coupling for the differential signals as such without the ground electrode (aka 3rd or right leg electrode) commonly used in ECG measurements and the grounded resistors at the input side of the amplifier.

Without in any way limiting the scope, interpretation, or application of the claims appearing below, a technical effect of one or more of the example embodiments disclosed herein is that an improved constant current source is provided. Another technical effect of one or more of the example embodiments is that there is provided a constant current source with increased load impedance tolerance. In some examples, load impedance tolerance may be doubled in comparison to prior solutions. In prior art solutions, for example increasing the load impedance from 20 kohm to 60 kohm may result in the current flowing through the load being distorted while with certain embodiments of the invention such distortion in the current flowing through the load may be avoided or at least reduced. Yet another technical effect of one or more of the example embodiments disclosed herein is that there is provided a constant current source with balanced output (i.e. same or substantially similar impedance at both output pins).

If desired, the different functions discussed herein may be performed in a different order and/or concurrently with each other. Furthermore, if desired, one or more of the before-described functions may be optional or may be combined.

Although various aspects of the invention are set out in the independent claims, other aspects of the invention comprise other combinations of features from the described embodiments and/or the dependent claims with the features of the independent claims, and not solely the combinations explicitly set out in the claims.

It is also noted herein that while the foregoing describes example embodiments of the invention, these descriptions should not be viewed in a limiting sense. Rather, there are several variations and modifications, which may be made without departing from the scope of the present invention as defined in the appended claims.

## Claims

1. An electronic circuit comprising:
an instrumentation amplifier circuit comprising a pair of instrumentation amplifiers arranged to provide differential output, and
a common-mode feedback circuit arranged to couple common-mode output of the pair of instrumentation amplifiers to input of the pair of instrumentation amplifiers.

2. The electronic circuit of claim 1, further comprising a first impedance network and a second impedance network, wherein
the first impedance network is coupled to input of the pair of instrumentation amplifiers,
the second impedance network is coupled to output of the pair of instrumentation amplifiers, and
the common-mode feedback circuit is arranged to couple a common-mode output of the second impedance network to a common-mode input of the first impedance network.

3. The electronic circuit of claim 1 or 2, further comprising a first low pass filter coupled to the input of the pair of instrumentation amplifiers.

4. The electronic circuit of any preceding claim, further comprising an output direct current block coupled to the output of the pair of instrumentation amplifiers.

5. The electronic circuit of any preceding claim, further comprising a second low pass filter coupled to the output of the pair of instrumentation amplifiers.

6. The electronic circuit of any preceding claim, further comprising a switch in the common-mode feedback circuit.

7. The electronic circuit of claim 6, wherein in a first setting the switch is configured to couple the common-mode feedback circuit to input of the pair of instrumentation amplifiers, and in a second setting the switch is configured to couple the common-mode feedback circuit to a substance that is being measured.

8. The electronic circuit of claim 6, wherein in a first setting the switch is configured to couple the common-mode feedback circuit to input of the pair of instrumentation amplifiers, and in a second setting the switch is configured to couple reference voltage to input of the pair of instrumentation amplifiers.

9. The electronic circuit of any preceding claim, wherein the electronic circuit is configured to measure certain biomedical substance.

10. The electronic circuit of claim 9, further comprising input electrodes configured to provide contact between the biomedical substance and the electronic circuit and feedback electrodes configured to couple the common-mode feedback circuit to the biomedical substance.

11. The electronic circuit of claim 10, further comprising shielded cables configured to couple the input electrodes to components of the electronic circuit, wherein the shields of the cables are configured to couple the common-mode feedback circuit to the biomedical substance.

12. The electronic circuit of claim 10 or 11, further comprising buffer amplifiers coupled to the input of the pair of instrumentation amplifiers.

13. The electronic circuit of any one of claims 9-12, further comprising a current source circuit comprising an instrumentation amplifier circuit, wherein the current source circuit is configured to feed current into the biomedical substance.

14. The electronic circuit of claim 13, wherein the current source circuit comprises two instrumentation amplifiers, two operational amplifiers connected as voltage followers and two resistors.

15. A biomedical instrumentation arrangement comprising an electronic circuit according to any one of claims 1-14.

16. An electrocardiography measurement arrangement comprising an electronic circuit according to any one of claims 1-14.

17. An electronic circuit comprising:
an instrumentation amplifier circuit comprising a pair of instrumentation amplifiers, wherein the pair of instrumentation amplifiers is configured to operate as a constant current source circuit configured to feed current to biomedical substance.

18. The electronic circuit of claim 17, wherein the constant current source circuit further comprises two operational amplifiers connected as voltage followers and two resistors.

19. The electronic circuit of claim 17 or 18, further comprising a measurement circuit configured to measure said biomedical substance, wherein the measurement circuit comprises
an instrumentation amplifier circuit comprising a pair of instrumentation amplifiers arranged to provide differential output, and
a common-mode feedback circuit arranged to couple common-mode output of the pair of instrumentation amplifiers to input of the pair of instrumentation amplifiers.
